# EUROPEAN PATENT APPLICATION

(11) **EP 1 443 546 A2**
(43) Date of publication of application: **04.08.2004**
(21) Application number: 04000247.9
(22) Date of filing: 08.01.2004
(51) Int. Cl.: H01L 21/48

(54) **Working method of metal material and semiconductor apparatus fabricated by the method**

(30) Priority: 28.01.2003 JP 2003018185
(71) Applicant: Hitachi Ltd., Tokyo (JP)
(72) Inventor: Kobayashi, Masuyuki, 1-5-1 Marunouchi Chiyoda Tokyo 100-8220 (JP); Harada, Kouji, 1-5-1 Marunouchi Chiyoda Tokyo 100-8220 (JP); Tokuda, Hiroatsu, 1-5-1 Marunouchi Chiyoda Tokyo 100-8220 (JP); Ojima, Kazuo, 1-5-1 Marunouchi Chiyoda Tokyo 100-8220 (JP)
(74) Representative: Beetz & Partner Patentanwälte

(57) **Abstract**

A method comprising constraining a circumference of a blank of a Cu-Mo alloy and one of surfaces to be worked with the use of a die, and using a working punch (33) or a counter punch (34) to apply working pressures to the other of the surfaces to be worked, thereby obtaining a cup-shaped body (27), and a semiconductor apparatus comprising a semiconductor chip fixed to an inner bottom surface of a cup-shaped diode base (27).

## Description

### Background of the Invention

The present invention relates to a working method of a metal material and a semiconductor apparatus fabricated by the method. In particular, the invention relates to a diode base for automotive alternating current generators, and rectifiers, and a manufacturing method thereof.

JP-A-8-115992 discloses a technique for forming a Cu-Mo sintered rolled material into a cup-shaped body. Also, the publication describes a forming method with drawing or squeezing.

JP-A-8-112634 describes a method of forming a sheet material with semi-punching.

JP-A-8-115992 describes forming with drawing or squeezing when a Cu-Mo sintered rolled material is to be formed into a cup-shaped body. However, the publication takes no account of crack in a material.

Also, JP-A-8-112634 describes forming of a sheet material with semi-punching. However, the publication gives no consideration to incorporation of the process, in which a projection is cut to make a cup-shaped body, material yield, and dimensional accuracy after cutting.

It is an object of the invention to provide a working method of a metal material, in which an alloy including a sintered rolled material is worked with high freedom, and a semiconductor apparatus making use of the working method.

### Summary of the Invention

In order to solve the problems, one of the inventions has a feature in constraining a blank comprising an alloy containing copper and performing plastic working to form an outer peripheral portion so as to form an inner space therein.

Also, the invention has a feature in that the alloy has characteristics having at least a coefficient of thermal expansion α of not less than 7 [10⁻⁶/K] but not greater than 13 [10⁻⁶/K] and a coefficient of thermal conductivity λ of not less than 150 [W/(m·K)] but not greater than 300 [W/(m·K)].

Further, the alloy is a Cu-Mo alloy or a Cu-W alloy and is subjected to plastic working by cold extrusion.

Also, the invention has a feature in that worked surfaces, to which working pressures are applied, has an area of not greater than 50 % of a whole surface area of the blank.

Other objects, features and advantages of the invention will become apparent from the following description of the embodiments of the invention taken in conjunction with the accompanying drawings.

### Brief Description of the Drawings

Fig. 1 is a cross sectional view showing an automotive alternating current generator.
Fig. 2 is a view showing a rectifier used in the generator shown in Fig. 1.
Fig. 3 is a longitudinal, cross sectional view showing a diode used in the generator shown in Fig. 1.
Figs. 4(a) to 4(c) illustrate the process of cold forging of a diode base.
Fig. 5 is a cross sectional view illustrating the manufacturing process of a diode base according to the invention.
Fig. 6 is a view illustrating the manufacturing process of a diode base blank.
Fig. 7 is a cross sectional view illustrating the manufacturing process of fins.
Fig. 8 is a view showing a Cu-Mo alloy, on which fins are worked.
Figs. 9(a) to 9(f) are cross sectional views showing examples of a cup-shaped configuration, which can be formed from an alloy.
Fig. 10 is a cross sectional view illustrating forward extrusion.
Figs. 11(a) and 11(b) are views showing a surface condition in plastic working of an alloy.
Fig. 12 is a view showing generation of crack in drawing or squeezing.
Fig. 13 is a view showing a diode base, according to the invention, made of an alloy.

### Description of the Invention

Embodiments of the invention are described with reference to the accompanying drawings.

Note that the following embodiments are those concerning an automobile alternating current generator but the present invention is not limited to these embodiments. The present invention, as described above, is one which forms a shape of an object by plastic working in order to restrain crack and variation of the dimensional accuracy resulted by working to an alloy containing copper, which is subject matter of the present invention, and is applicable to an electric instruments, electric machines, electronic instruments, device and the like. In particular, the present invention is effective in forming a cup-shape.

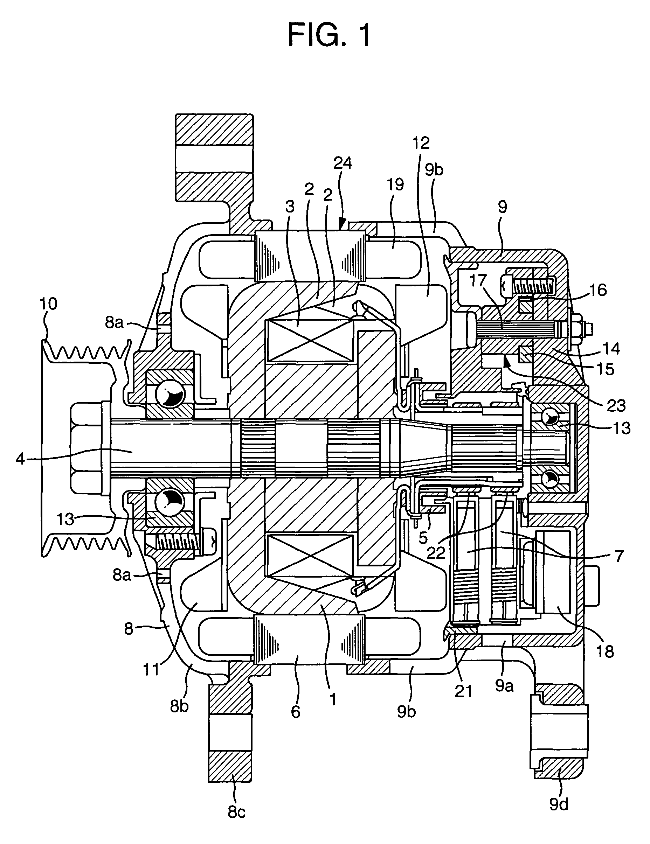

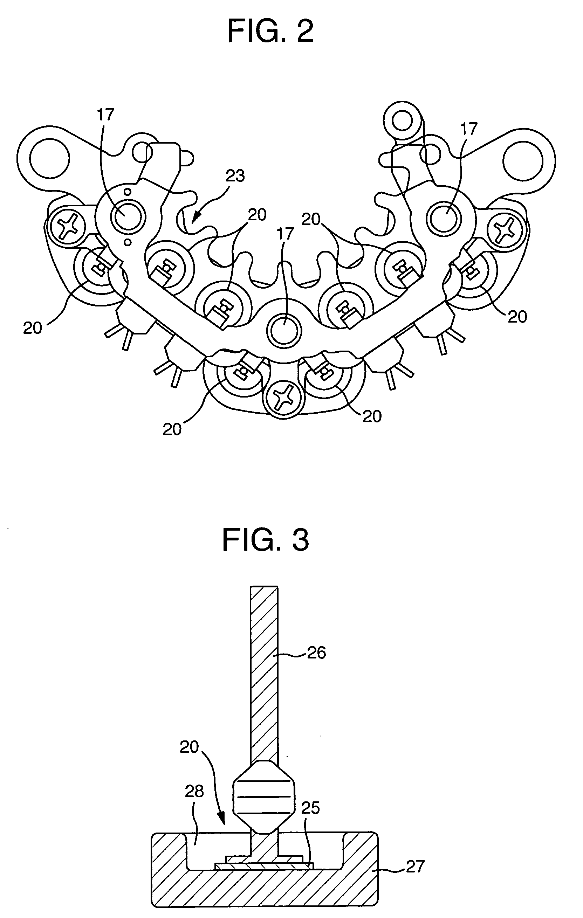

Fig. 1 is a cross sectional view showing an automotive alternating current generator, and Fig. 2 is a view illustrating a rectifier for the automotive alternating current generator shown in Fig. 1.

A rotor 1 is fixed to a rotating shaft 4 to be excited by an exciting coil 4, and generates N poles and S poles with rotor pawls 2 in a circumferential direction of the rotor according to the number of poles. The exciting coil 3 is supplied with direct current through slip rings. The slip rings each comprises a brush 7 mainly made of carbon and held by a brush holder and a brush ring 22 fixed to the rotating shaft 4. In addition, a connection terminal 5 is provided between the slip rings and the exciting coil 3 to afford connection of lead wires from the slip rings and lead wires of the exciting coil 3 there, thus improving an assembling easiness. The exciting coil 3 comprises a bobbin (not shown), which possesses electric insulation and around which lead wire with an insulating coating is wound many turns. Preferably, in order that heat generated on the exciting coil 3 is easily transmitted to the rotor, the bobbin is preferably made of a material having a small heat resistance, for example, a composite material obtained by coating an insulating paint or resin on surfaces of an organic resin such as epoxy resin, in which aluminum oxide powder is dispersed and mixed to enhance a coefficient of thermal conductivity thereof, or of metal such as iron.

Centrifugal fans 11, 12 are provided on both end surfaces of the rotor 1. Openings 8a, 8b, 9a, 9b are formed in locations on a front bracket 8 and a rear bracket 9 to be communicated to suction sides and discharge sides of the fans 11, 12. The fan 11 sucks a cooling air from the opening 8a and discharges the air from the opening 8b after passing through the front bracket. Also, the fan 12 sucks a cooling air from the opening 9a and discharges the air from the opening 9b after passing through the rear bracket. On a side of the rear bracket 9, a fan guide 21 structurally separates suction and discharge sides of the fan 12 from each other, and the openings 9a, 9b are positioned on both sides of the fan guide 21. It is desired that a blast area defined by the both brackets 8, 9 and the fan guide 21 be made as large as possible not to make a blast resistance to the fan.

A stator 24 comprises stator coils 19 embedded in slots provided on a stator core 6 composed of laminated steel sheets. The number of the slots amounts to three times the number of poles since three-phase alternating current is to be generated. The stator coils 19 comprises many turns of lead wire with an insulating coating, and insulation serving also as protection of the insulation on conductors is provided by inserting an insulating sheet between the coils and the stator core 6 in the slots. It is desired that the lead wire with the insulating coating be square wire in order to increase occupancy of the conductors in the slots. However, round wire is rather easy to manufacture and wind. In either case, varnish, resin, or the like is impregnated in voids within the slots to fix the conductors together and to permit heat generated by the coils to be easily transmitted to the stator core 6. The stator core 6 is interposed between the front bracket 8 and the rear bracket 9 to be firmly fixed thereto by means of through-bolts (not shown).

The rotating shaft 4 is rotatably supported by bearings 13 at both ends thereof on the front bracket 8 and the rear bracket 9. A pulley 10 for transmitting power from an engine is provided on a front-bracket side end of the rotating shaft 4. Support legs 8c, 9d for fixing a body of the automotive alternating current generator to an engine are provided on the front bracket 8 and the rear bracket 9. A voltage regulator 18 for regulating current to the exciting coil 3 to make generated voltage constant irrespective of the rotational speed, and a rectifier 23 for converting alternating current generated by the stator coils 19 into direct current are fixed to the rear bracket 9.

The rectifier 23 comprises diodes 20, a diode minus cooling plate 14 and a diode plus cooling plate 15, to which the diodes 20 are mounted, an insulating sheet (not shown) arranged between the both cooling plates 14, 15, a mold terminal 16, and a fixing member 17 for fixing these parts to the rear bracket 9. Concretely, the rectifier 23 is fixed to the rear bracket 9 by arranging the diode minus cooling plate 14, the insulating sheet, the diode plus cooling plate 15, and the mold terminal 16 in this order in an overlapped state from an inner side of the rear bracket 9, providing through-holes extending through these elements, passing the fixing member 17 from a side of the mold terminal 16, abutting one end of the fixing member 17 against the mold terminal 16, fixing a tip end of the fixing member to the rear bracket 9, and pressing the mold terminal 16 against the rear bracket 9.

The diode minus cooling plate 14 is made of a member having favorable thermal conductive properties and a plurality of diodes 20 is mounted on a surface of the diode minus cooling plate 14 toward the rear bracket. A thermally conductive grease or the like is applied between the diode minus cooling plate and the rear bracket 9 to reduce heat resistance between the both, so that the diode minus cooling plate 14 is thermally connected to the rear bracket 9. Thereby, heat generated by the diodes 20 is transmitted to the rear bracket 9 to be radiated from the rear bracket 9.

The diode plus cooling plate 15 is made of a member having favorable thermal conductive properties. A plurality of diodes 20 is mounted on a surface of the plate 15 opposed to the rear bracket 9. An insulating sheet constituting an insulating member and the mold terminal 16 are arranged between the diode plus cooling plate 15 and the diode minus cooling plate 14, and the plate 15 is electrically insulated therefrom and thermally connected thereto.

Desirably, the insulating sheet interposed between the diode minus cooling plate 14 and the diode plus cooling plate 15 protrudes outward from the both cooling plates 14, 15 to keep an insulation distance between positive and negative poles. The insulating sheet having a large thermal conductivity is used in order to reduce heat resistance between the diode minus cooling plate 14 and the diode plus cooling plate 15. Thereby, a part of heat generated from the diodes 20 mounted on the diode plus cooling plate 15 is transmitted from the diode plus cooling plate 15 through the insulating sheet to the diode minus cooling plate 14, and further to the rear bracket 9 to be radiated from the rear bracket 9.

The mold terminal 16 serves to fix diode terminals and stator coil lead portions, and is made of a member having electrically insulating properties. The member is desirably favorable in thermal conduction. Thereby, the fixing member 17 is electrically insulated from the diode plus cooling plate 15.

The fixing member 17 is made of a member having favorable thermal conductive properties, and thermally connected at a side end thereof and mounted to the rear bracket 9.

That is, the fixing member 17 is thermally connected to the diode plus cooling plate 15 while maintained in electric insulation therefrom, and the fixing member 17 is made favorable in thermal conductive property. Besides, the fixing member is thermally connected and fixed to the rear bracket 9. Thereby, heat generated from the diodes 20 mounted on the diode plus cooling plate 15 can be transmitted to the fixing member 17. Further, heat can be transmitted to the rear bracket 9 from the fixing member 17 to be radiated from the rear bracket 9. Thereby, it is possible to cool the diodes 20 without increasing the number of parts.

The invention includes, for example, the following constitution. That is, the invention includes a semiconductor apparatus comprising a cup-shaped diode base mounted on a radiating plate, a semiconductor chip fixed to an inner bottom surface of the diode base through a junction member, and lead wires connected to the semiconductor chip and to external devices, and wherein the diode base is made of an alloy material and has a coefficient of thermal expansion α of 7 to 13 [10⁻⁶/K] and a coefficient of thermal conductivity λ of 150 [W/(m·K)].

Preferably, the semiconductor chip is joined directly to the diode base. Also, the diode base is preferably made of a Cu-Mo sintered rolled material. Further, the diode base is more preferably made of an alloy material containing about 35 % of Cu and about 65 % of Mo. And the semiconductor apparatus or diodes are applied to full-wave rectifiers for automotive alternating current generators.

Also, in the case where a cup-shaped body is formed by constraining a circumference of a blank of a Cu-Mo sintered rolled material and one of surfaces to be worked with the use of a die, and applying working pressures to the other of the surfaces to be worked with the use of a working punch or a counter punch, an area, to which working pressures are applied, is preferably set to at most 50 % of a whole surface area of the blank. The material is caused to flow around the working punch, thus obtaining a cup-shaped product. Alternatively, by pressing the other of the surfaces to be worked with the working punch, a product such as cup-shaped element, member, parts, or the like is obtained. The cup-shaped body constitutes the diode base.

A diode base for rectifiers comprises a cup-shaped body formed by constraining a circumference of a blank of a Cu-Mo sintered rolled material and one of surfaces to be worked, applying working pressures to the other of the surfaces to be worked with the use of a working punch or a counter punch, and setting an area, to which working pressures are applied, to at most 50 % of a whole surface area of the blank.

Cooling fins comprise a rolled metal material having a wave-shaped cross section and is disposed to permit transmission of heat from semiconductors. The rolled metal material is formed by constraining a circumference of a blank of a Cu-Mo sintered rolled material and one of surfaces to be worked with the use of a die, and using a working punch or a counter punch of which end surface has a wave-shaped cross section to apply working pressures to that area of the other of the surfaces to be worked, which amounts to at most 50 % of a whole surface area of the blank. The cooling fins serve also as those for semiconductors.

A diode 20 according to the embodiment is described below with reference to Fig. 3.

As shown in Fig. 3, the diode 20 comprises a semiconductor chip 25, one surface of which is connected to a lead wire 26 by means of solder (not shown), and the other surface of which is connected to a diode base 27, composed of a cup-shaped member, by means of solder (not shown). A sealing material 28 such as silicone or the like is filled in a recess of the diode base 27 to protect the semiconductor chip 25, and junctions between the semiconductor chip 25 and the lead wire and between the semiconductor chip and the diode base 27.

Conventionally, diode bases are made of only Cu since work crack is generated in an alloy. The diode base 27 in the invention, however, is made of a Cu-Mo alloy or a Cu-W alloy so as to prevent generation of work crack. By forming the diode base 27 from the Cu-Mo alloy, a difference in coefficient of thermal expansion α between the semiconductor chip 25 and the diode base 27 can be made smaller than that in the case where the diode base is made of Cu. Conventionally, a member having a coefficient of thermal expansion between coefficients of thermal expansion of a chip and a diode base is inserted as a cushioning material between the both in order to restrict a difference in coefficient of thermal expansion. Thus, α1<α3<α2 or α2<α3<α1 is set where α1, α2 and α3, respectively, indicate coefficients of thermal expansion of the chip, the diode base and the cushioning material. According to the embodiment, however, a difference between α1 and α2 can be made smaller than that in the related art. Thereby, a chip and a diode base can be joined directly to each other by solder. Further, by joining a chip and a diode base directly to each other by solder, a heat transfer coefficient can be heightened as compared with the case where a separate member is arranged between the both. Thereby, it is possible to improve diodes in heat radiation performance. Also, by joining a chip and a diode base directly to each other by solder, man-hour for soldering can be reduced as compared with the case where a separate member is arranged between the both. Thereby, it is possible to enhance productivity.

More concretely, the diode base is desirably made of an alloy material to have a coefficient of thermal expansion α of 7 to 13 [10⁻⁶/K] and a coefficient of thermal conductivity λ of 150 to 300 [W/(m·K)]. This is because the inventors of the present application have found as results of various examinations that setting of such numerical range leads to prevention of crack due to a difference in thermal expansion between the diode base and the chip. Also, the inventors of the present application have found as results of various examinations that as far as being within the numerical range, it is possible to ensure a heat transfer coefficient required for cooling.

Here, a method of forming a diode base from a Cu-Mo alloy is described.

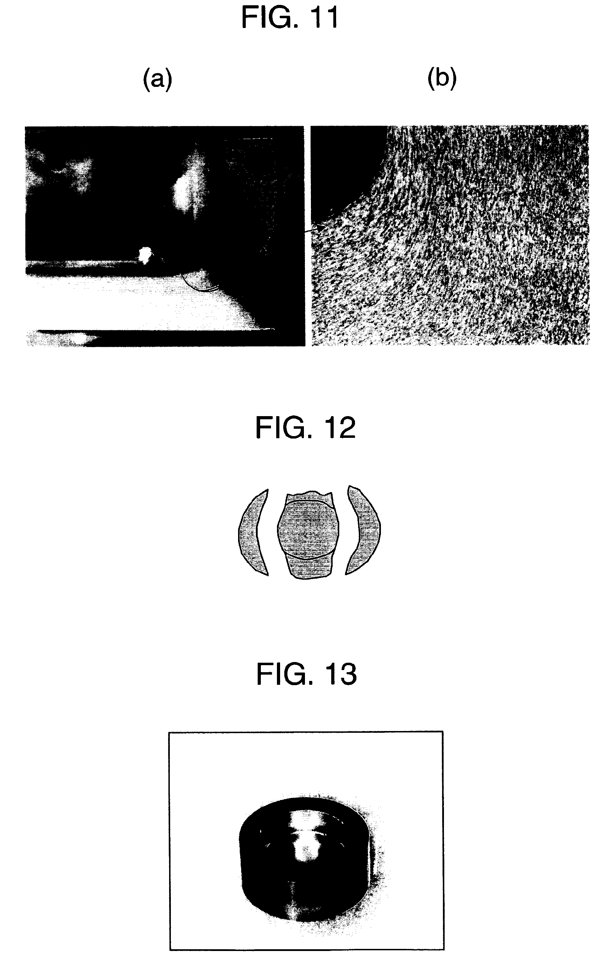

Such being the case, the inventors of the present application have made various examinations with respect to a method of working an alloy with a Cu-Mo alloy as the start. As a result, it has been found that crack is very simply generated in the Cu-Mo alloy when drawing or squeezing is performed. Also, it has become apparent that crack is generated on that surface, which is subjected to tension, and such tension is resulted on many surfaces in drawing or squeezing. For example, when drawing or squeezing is applied to an alloy member as shown in Fig. 12, crack is generated to cause division of the alloy member into three pieces.

The inventors of the present application have examined a method of working sintered rolled materials with the Cu-Mo alloy as the start, in which method crack is hard to generate. A working method having been found as a result is described below.

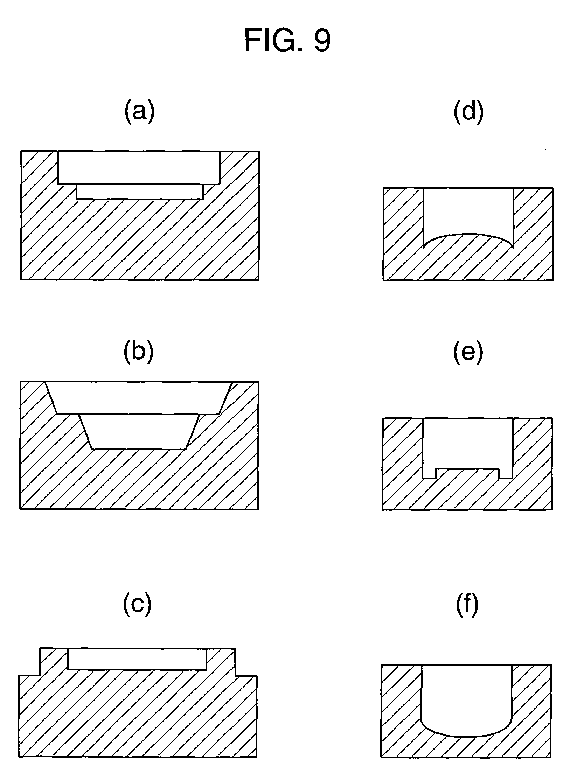

Fig. 13 is a view showing a diode base as a product. As examples of other shapes than that shown in the drawing, a cup-shaped member has an internal configuration composed of a plurality of steps as shown in, for example, Fig. 9(a). As shown in Fig. 9(b), an internal configuration of a cup-shaped member is tapered. As shown in Fig. 9(c), a cup-shaped member is provided with a columnar or prismatic pedestal. Also, a cup-shaped member may have an internal configuration as shown in Figs. 9(d), 9(e), and 9(f). Not only such configurations but also all configurations capable of holding the semiconductor chip 25, the lead wire 26, and the sealing material 28 such as silicone or the like are conceivable.

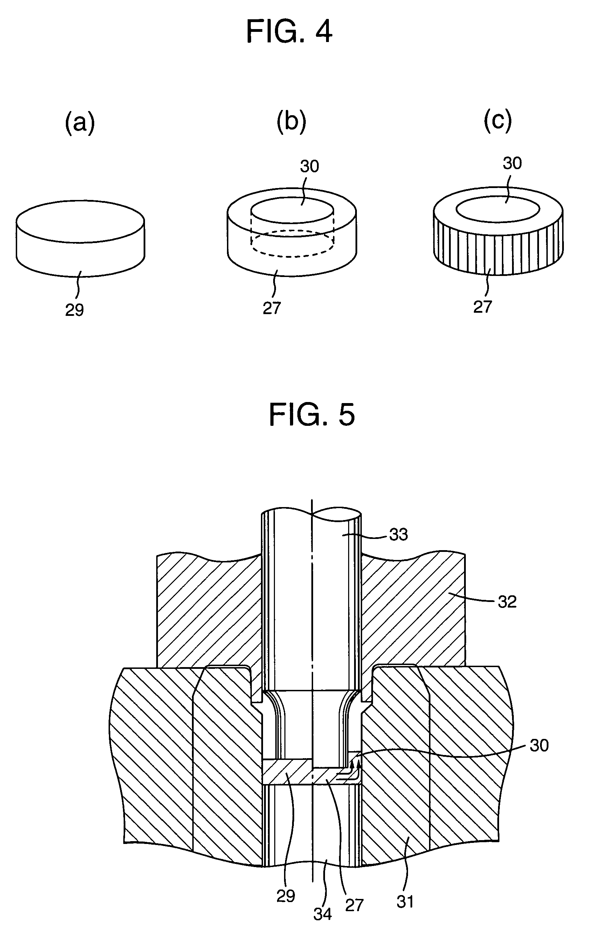

A method of manufacturing a diode base 27 made of the Cu-Mo alloy in the embodiment is described with reference to Figs. 4 and 5.

Fig. 4, (a) to (c) show the processes, in which a diode base 27 is formed from a blank 29. The blank 29 is put in a state of being cut from a rolled material of the Cu-Mo alloy.

Fig. 5 shows a state, in which the process of plastic working (the process of cold forging) of Fig. 4(b) is being carried out.

The procedure of working is described below. First, as shown in Fig. 4(a), a blank 29 is cut from a rolled material. Subsequently, a counter punch 34 is used in combination to perform rearward extrusion forming. Such extrusion makes it possible to form a part of the Cu-Mo alloy, which has a cylindrical portion (recess) 30 centrally thereof as shown in Fig. 4(b). Subsequently, knurling working is performed on an outer periphery of the part to finish a diode base 27 as shown in Fig. 4(c).

Here, rearward extrusion is described. First, the blank 29 is constrained by a hollow die (or a female die) 31 and a counter punch (or a female pin) 34 (the left side in Fig. 5). Subsequently, pressing is effected by a working punch (or a punch) 33 that is guided by a guide 32 (the right side in Fig. 5). In this extrusion, most portions of external surfaces of the blank 29 can be constrained by the working punch 33, the hollow die 31, and the counter punch 34. Such constraint makes it possible to prevent crack due to tension applied on the constrained surfaces. That is, when the working punch 33 is pushed downward in Fig. 5 in this state, the material flows as shown by arrows. Thereby, the Cu-Mo alloy can be formed while crack is prevented.

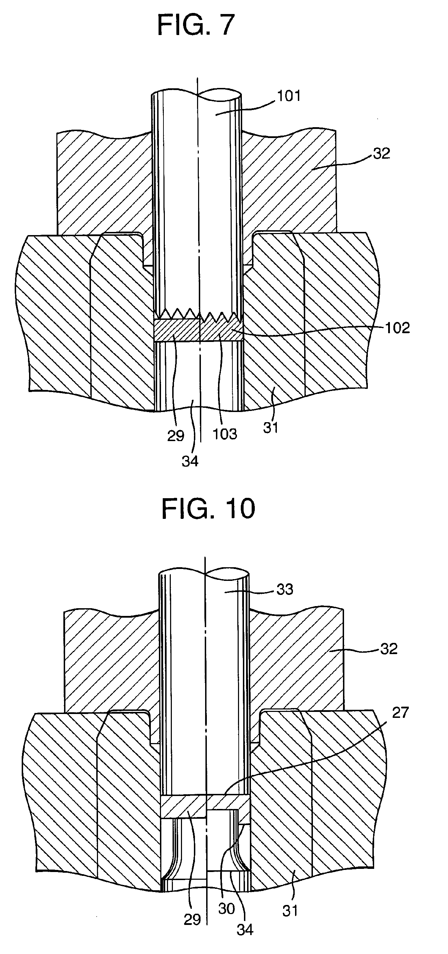

In addition, an equivalent cup-shaped member can be obtained in the embodiment shown in Fig. 5 even when forming is performed by constraining the blank 29 with the hollow die 31 and the working punch 33, and moving the counter punch 34 to press the blank 29 to form the cylindrical portion 30 by means of forward extrusion. In this case, forming is performed by making the working punch stationary and moving the counter punch toward the working punch in the respective drawings. Such forward extrusion is effected as shown in Fig. 10. First, the blank 29 is constrained by the hollow die 31 and the counter punch 34 (the left side in Fig. 10). Subsequently, pressing is effected by the working punch 33 that is guided by the guide 32 (the right side in Fig. 10). In this extrusion, most portions of external surfaces of the blank 29 can be constrained by the working punch 33, the hollow die 31, and the counter punch 34. Such constraint makes it possible to prevent crack due to tension applied on the constrained surfaces. That is, when the working punch 33 is pushed downward in Fig. 10 in this state, the material flows as shown by arrows. Thereby, it is possible to form the Cu-Mo alloy while crack is prevented.

Conventionally, only very simple forming such as cutting can be performed to Co-Mo alloy since it has been not possible to overcome problems of crack. In the case where a complicated configuration is to be formed, it has been possible to select only a working method, for example, cutting, involving much man-hour. Cutting is bad in yield of material and adoption thereof is problematic in terms of productive efficiency.

However, the method found by the inventors of the present application makes it possible to form the Cu-Mo alloy into a complicated configuration while ensuring the yield of material. Here, the complicated configuration means a configuration with irregularity. That is, it is possible to form, for example, radiation fins for use in cooling of semiconductors, as well as a cup-shaped configuration having a recess as in the embodiment.

An embodiment, in which radiation fins are formed, is described with reference to Fig. 7. Radiation fins can be formed by replacing the working punch shown in Fig. 5 by a working punch 101 having a mountain-shaped cross section. Since the procedure of working and designations of respective parts are the same as those in Fig. 5, an explanation for the same portions as those in Fig. 5 is omitted.

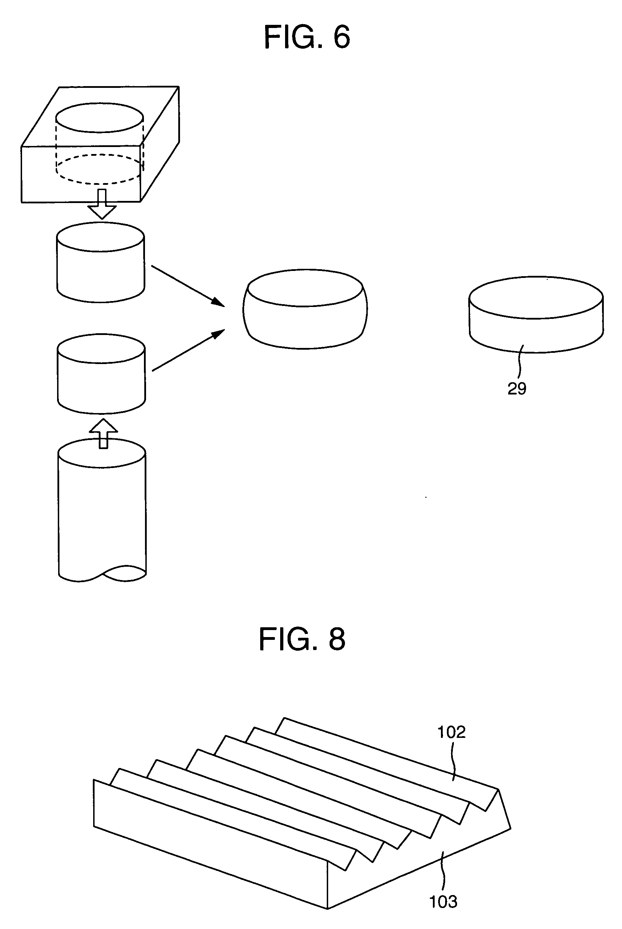

The fin working punch 101 has a mountain-shaped cross section at a tip end thereof. The punch is guided by the guide 32 to press a blank 29. In this extrusion, most portions of external surfaces of the blank 29 can be constrained by the fin working punch 101, the hollow die 31, and the counter punch 34. Such constraint makes it possible to prevent crack due to tension applied on the constrained surfaces. That is, when the fin working punch 101 is pushed downward in Fig. 7 in this state, the material flows toward apices of the mountain-shaped cross section of the fin working punch 101. Thereby, fins 102 can be formed from the Cu-Mo alloy while crack is prevented. According to the method described above, it is possible to form radiation fins 103. The radiation fins 103 are shown in Fig. 8. While the rectangular radiation fins are fabricated in the embodiment, it is possible to similarly form disk-shaped fins. Also, by making the mountain shape of the fin working punch sharp (that is, making angles of the apices small), it is possible to fabricate cooling fins having a high radiator efficiency.

In the embodiment, cutting is performed to obtain the blank 29. As shown in, for example, Fig. 6, however, the Cu-Mo alloy may be subjected to electrical discharge machining, and plastic working as by cold forging such as punching, cutting, compression.

While drawing or squeezing mainly generates tensile stress to thereby cause crack or the like in a material, rearward extrusion forming in the embodiment mainly generates compressive stress whereby forming can be made without generation of crack or the like in a material.

In addition, in the case of plastic working, for example, rearward extrusion of an alloy according to the invention, the blank 29 is constrained by the female pin 34 and the female die 31 and worked by means of the working punch 33, the alloy flows rearwardly of the working punch 33. When a cross section of the product is cut and a structure thereof is observed, flow of metal can be seen as shown in Figs. 11(a) and 11(b). In the working method according to the invention, such flow of metal certainly appears, and so it is found that plastic working has been effected provided that such flow is generated in metal.

According to the respective embodiments described above, it is possible to provide a semiconductor apparatus having a high cooling capacity. Also, a method of manufacturing a diode base is provided to be high in accuracy and excellent in productivity.

Also, since the Cu-Mo alloy can be worked in plastic working, it is possible to attain an improvement in yield of material as compared with the case in cutting.

Also, it is possible to provide a semiconductor apparatus enhanced in cooling capacity.

The invention can be applied to members, parts, elements, or products, which are to be formed in plastic working from alloys including the Cu-Mo alloy, realize members, parts, elements, or products, which are enhanced in cooling capacity, and bring about an excellent productivity.

It should be further understood by those skilled in the art that although the foregoing description has been made on embodiments of the invention, the invention is not limited thereto and various changes and modifications may be made without departing from the spirit of the invention and the scope of the appended claims.

## Claims

1. A working method of an alloy containing copper, the method comprising constraining a blank of an alloy containing copper and forming an outer peripheral portion so as to form an inner space therein by plastic working.

2. The working method of an alloy containing copper according to claim 1, wherein the alloy is one of copper and molybdenum or one of copper and tungsten.

3. The working method of an alloy containing copper according to claim 1, wherein the blank is formed into a cup-shape by plastic working.

4. The working method of an alloy containing copper according to claim 1, wherein the inner space is a stepped one.

5. A semiconductor apparatus comprising a cup-shaped diode base (27) mounted on a radiating plate, a semiconductor chip (25) fixed to an inner bottom surface of the diode base through a junction member, and lead wires (26) connected to the semiconductor chip and to external devices, and wherein the diode base is made of a Cu-Mo alloy or a Cu-W alloy having a coefficient of thermal expansion of not less than 7 [10⁻⁶/K] but not greater than 13 [10⁻⁶/K] and a coefficient of thermal conductivity of not less than 150 [w/(m·K)] but not greater than 300 [W/(m·K)] and the alloy is subjected to plastic working by cold extrusion into a cup shape.

6. The semiconductor apparatus according to claim 5, wherein the cold extrusion is rearward extrusion.

7. The semiconductor apparatus according to claim 5, wherein the cold extrusion is forward extrusion.

8. The semiconductor apparatus according to claim 5, wherein the semiconductor chip is joined to the diode base through solder.

9. The semiconductor apparatus according to claim 5, wherein the diode base is formed from a Cu-Mo sintered rolled material.

10. The semiconductor apparatus according to claim 9, wherein the Cu-Mo sintered rolled material contains about 35 % of Cu by weight and about 65 % of Mo by weight.

11. The semiconductor apparatus according to claim 5, wherein the semiconductor apparatus constitutes a full-wave rectifier (17, 20, 23) in an automotive alternating current generator.

12. A working method of a metal material, the method comprising constraining a circumference of a blank made of a Cu-Mo sintered rolled material and one of surfaces to be worked with the use of a die, and applying working pressures to the other of the surfaces to be worked with the use of a punch to form a cup-shaped body, and wherein the surfaces to be worked, to which the working pressures are applied, amount to not greater than 50 % of a whole surface area of the blank.

13. The working method according to claim 12, wherein the material is caused to flow around the punch to form the cup-shaped body.

14. The working method according to claim 12, wherein the cup-shaped body makes a diode base.

15. The working method according to claim 12, wherein an end surface of the punch has a wave-shaped cross section.
